# EUROPEAN PATENT APPLICATION

(11) **EP 2 423 962 A1**
(43) Date of publication of application: **29.02.2012**
(21) Application number: 11183469.3
(22) Date of filing: 05.12.2007
(51) Int. Cl.: H01L 27/146, H04N 5/361

(54) **Long exposure digital image sensor system**

(30) Priority: 19.03.2007 DK 200700417
(62) Divisional of application: 07846443.5
(71) Applicant: Phase One A/S, 2000 Frederiksberg (DK)
(72) Inventor: Andersen, Thomas, 4600 Køge (DK)
(74) Representative: Plougmann & Vingtoft A/S

(57) **Abstract**

The invention relates to an image sensor system which includes an image sensor (CCD). The image from the image sensor is read out as a video signal. In addition to image values, the video signal also contains electrical and optical black noise.
Black noise removal from the video signal is based on read out additional pixels that do not directly originate from image pixels to avoid clipping during clamping and analogue-to digital conversion. Furthermore, the image sensor system performs power control for the image sensor output amplifier to reduce unnecessary image sensor heating during image exposure. Particularly during long exposure unwanted sensor heating results in increased and unequally distributed black noise that can be lowered by reducing power consumption of the sensor output amplifier which is only used during reading out pixels but not needed during image exposure. To reduce amplifier power consumption during image exposure periods the system performs current control of the amplifier output stage.

## Description

### FIELD OF THE INVENTION

The invention relates to a method for improving image quality of a digital image sensor, and in particular to improving the image quality of a digital image sensor for long exposure periods.

### BACKGROUND OF THE INVENTION

The quality of images from digital image processors is affected by electric noise from various electrical and optical noise sources. In particular when using long exposure times for imaging under dark light conditions, the noise source may significantly degrade the image quality. The digital image may be processed using measured or estimated noise values in order to remove such noise effects from the image.

One noise source is optical black noise which is dependent on temperature of the image sensor. Images can be corrected for optical black noise by use of electrical values obtained from shielded pixels of the image sensor. For example, by clamping the image signal with respect to such electrical values obtained from shielded pixels.

In connection with long exposure imaging, localised heating of the image sensor is a problem, since localised heating causes localised noise. Such localised heating may be caused by e.g. amplifier circuits located close to the image sensor.

Another problem is clipping (i.e. the max signal value is limited to a threshold values) of the image signal by an analogue-to-digital converter. The noise values which are added to images values which implies that the image signal may be so large that the signal is clipped, for example by analogue-to-digital converter.

JP2005303592 discloses a solid state imaging device including a first optical black level pixel which is formed under a light shielding film and which does not have a photoelectric conversion function, and a second optical black level pixel with a photoelectric conversion function. The signal processing method for determining the optical black level includes a step of selectively clamping any of an output signal from the first optical black level pixel, and an output signal from the second optical black level pixel according to the exposure time and the two black levels.

Whereas JP2005303592 discloses a method for correcting for optical black noise by using values from shielded or non-shielded pixels, JP2005303592 does not effectively disclose how to improve image quality due to other noise sources and due to clipping of the image signal.

### SUMMARY OF THE INVENTION

Accordingly, the invention preferably seeks to mitigate, alleviate or eliminate one or more of the above mentioned problems singly or in any combination. In particular, it may be seen as an object of the present invention to provide a method and an apparatus capable of capable of improving the image quality in connection with long exposure imaging by clamping the image signal using an electric black reference signal.

This object and several other objects are obtained in a first aspect of the invention by providing an image sensor system according to the independent claims.

The invention is particularly, but not exclusively, advantageous for improving the image quality in connection with long exposure imaging.

Accordingly, an embodiment of the first aspect of the invention relates to an image sensor system configured to adjust a reference level of an image signal readout from an electronic image sensor where the image signal represents analogue pixel values of a digital image recorded by the image sensor, the image sensor system comprising,
- an electric reference generator configured to provide an electric black reference signal,
- a clamping circuit configured to obtain a clamped image signal by adjusting the reference level of the image signal readout from the electronic image sensor using the electric black reference signal,
- an analogue to digital converter having a lower clipping reference for digitizing the clamped image signal,
   wherein the reference level of the image signal is adjusted relative to the lower clipping reference for avoiding clipping of the clamped image signal, and the clamped image signal is obtained prior to digitizing the clamped image signal.

The electric black reference signal may represent electric black noise and may, therefore, correspond to the electric black noise contained in the image signal. Thus, by adjusting the image signal using the electric black signal, for example by subtracting the electric black signal from the image signal, a clamped image signal substantially free from electric black noise may be achieved.

Another advantage related to adjusting the image signal using the electric black signal may be achieved, since the clamped image signal may not be exposed to clipping in a possible subsequent analogue-to-digital converter where the clamped signal is digitized.

In an embodiment, electric black reference signal may represent electric noise embedded in the image signal. It is understood, that representing electric noise may be understood as being substantially equal to or representing a fraction of the embedded electric noise, i.e. the noise contained in the image signal. Thus, the electric black reference signal may represent e.g. 50 percent of the embedded electric noise.

In an embodiment, the electric black reference signal may be substantially free from optical noise being embedded in the image signal. Thus, depending on how the electric black reference signal is obtained, the electric reference signal may contain an amount of optical noise.

In an embodiment, the electric black reference signal may be generated from one or more additional values transmitted by a horizontal register, where the additional values are transmitted by the horizontal register subsequent to pixel values.

In another corresponding embodiment, the electric black reference signal is generated from one or more additional values transmitted from one or more vertical registers of the image sensor, where the additional values are transmitted from the vertical registers subsequent to pixel values.

Thus, such additional values may not be generated due to optical radiation since the values may be generated by an electric register circuit. It may be an advantage that the electric black reference signal is generated from one or more additional values transmitted by a horizontal register, since the electric reference value is then substantially free from optical noise.

In a similar embodiment, the electric black reference signal is generated by a feedback circuit comprising a processing device configured to extract electric noise values from a digitised image signal and converting the extracted electric noise values into the electric black reference signal.

In a further embodiment, in the image sensor system according to the first aspect,
- the electric reference generator is configured to provide an electric black reference signal comprising values of one or more lines of the image sensor, and
- the clamping circuit is configured to adjust one or more reference levels of the image signal related to corresponding one or more of lines of the image sensor using the electric black reference signal, where the adjusted reference levels of the image signal have values relative to the lower clipping reference for avoiding clipping of the clamped image signal.

Thus, it may be an advantage to use values from one or more image sensor lines for generating the electric black reference value since this allows the claiming circuit to adjust corresponding one or more signal values from one or more lines of the image signal. Since the image signal may be adjusted for a plurality of lines, an improved image quality may advantageously be obtained and/or a reduced risk for clipping in the ADC may advantageously be achieved.

In an embodiment, in the image sensor system according to the first aspect,
- the analogue to digital converter is configured to convert the clamped image signal into a digitized pixel signal, and the system further comprises,
- a black level compensator configured to adjust the digitized image signal related to each line of the image sensor, where each line is adjusted using values originating from one or more shielded pixels from one or more lines to obtain a black-level conditioned digitized image signal.

Thus, in addition to correcting for electric black noise by clamping, the image signal may be corrected for unwanted optical black noise.

In an embodiment, the image sensor system further comprises a selector for selecting an exposure mode selected from the list comprising: a short exposure mode and a long exposure mode, wherein
- the selector is configured to provide the clamping circuit with the electric black reference signal when the long exposure mode is selected, and
- the selector is configured to provide the clamping circuit with an optical black reference signal when the short exposure mode is selected.

Thus, when capturing an image using a long exposure time (e.g. under dark light conditions), the clamping circuit may advantageously be provided with the electric black reference signal, since this may give the best image quality under long exposures. Oppositely, when capturing an image using a short exposure time, the clamping circuit may advantageously be provided with the optical black reference signal (e.g. obtained from shielded pixels), since this may give the best image quality under short exposure times.

In an embodiment, the image sensor system according to the first aspect, further comprises
- an amplifier capable of amplifying the image signal,
- an output stage capable of conditioning the amplified image signal, and
- a current controller capable of controlling a power consumption of the amplifier during the image exposure period by controlling a current in the output stage for reducing heating of the image sensor.

It may be an advantage to use a current controller, since the current controller may be capable of reducing heating and, thereby, improve the image quality, in particular for long exposure imaging.

In a second aspect, the invention relates to an electronic chip system configured to adjust a reference level of an image signal readout from an electronic image sensor, the image signal representing analogue pixel values of a digital image recorded by the image sensor, the electronic chip system comprising,
- an electric reference generator configured to provide an electric black reference signal,
- a clamping circuit configured to obtain a clamped image signal by adjusting the reference level of the image signal readout from the electronic image sensor using the electric black reference signal,
wherein the reference level of the image signal is adjusted relative to a lower ADC-clipping reference for avoiding clipping of the clamped image signal.

In a third aspect, the invention relates to a method for adjusting a reference level of an image signal readout from an electronic image sensor, the image signal representing analogue pixel values of a digital image recorded by the image sensor, the method comprising,
- providing an electric black reference signal from an electric reference generator, - adjusting the reference level of the image signal read out from the electronic image sensor using the electric black reference signal for obtaining a clamped image signal,
- digitizing the clamped image signal using an analogue to digital converter (ADC) having a lower clipping reference,
wherein the reference level of the image signal is adjusted relative to the lower clipping reference for avoiding clipping of the clamped image signal, and the clamped image signal is obtained prior to digitizing the clamped image signal.

In a fourth aspect, the invention relates to an image sensor system configured to reduce amplifier heating of electronic image sensor, the image sensor being configured to provide an image signal representing analogue pixel values of a digital image recorded by the image sensor, the image sensor system comprising
- an amplifier capable of amplifying the image signal,
- an output stage capable of conditioning the amplified image signal, and
- a current controller capable of controlling a power consumption of the amplifier during the image exposure period by controlling a current in the output stage for reducing the heating of the image sensor.

It may be an advantage to use a current controller, since the current controller may be capable of reducing heating and, thereby, improve the image quality, in particular for long exposure imaging. That is, heating of the image sensor pixels may cause increased generation of optical black noise, which may cause reduced image quality.

In an embodiment, in the image sensor system according to the fourth aspect, the current controller is capable of maintaining an output voltage of the output stage substantially constant during the image exposure period. It may be an advantage that the output voltage is maintained, since this may reduce the risk for clipping of the image signal.

In an embodiment, in the image sensor system according to the fourth aspect, the current controller is a controllable resistor.

In an embodiment, in the image sensor system according to the fourth aspect, the output stage is a semiconductor device configured as current buffer.

The first, second, third and fourth aspects of the present invention may each be combined with any of the other aspects. These and other aspects of the invention will be apparent from and elucidated with reference to the embodiments described hereinafter.

In summary, the invention relates to an image sensor system which includes an image sensor. The image from the image sensor may be read out as a video signal. In addition to image values, the video signal may also contain electrical and optical black noise. Such noises should be removed from the video signal. A value corresponding to the electrical black noise may be obtained from the image sensor by reading out same additional pixel values which does not originate from image pixels. By subtracting this value from the video signal, a clamped video signal may be obtained in which the electrical black noise has been reduced or removed. Additionally, by subtracting the electric block noise value, it may be achieved that the clamped video signal is not clipped in the analogue-to-digital converter. The optical black noise may be removed from the signal outputted by the ADC.

### BRIEF DESCRIPTION OF THE FIGURES

The present invention will now be explained, by way of example only, with reference to the accompanying Figures, where
Figure 1 illustrates an image sensor and an image sensor signal,
Figure 2 illustrates optical noise and electrical noise as a function of exposure time,
Figure 3 shows an example of an electric reference generator,
Figure 4 shows an optical black noise compensator,
Figure 5 illustrates localised heating of an image sensor due to amplifier heating,
Figure 6 shows an output stage connected to the output of an image sensor amplifier,
Figure 7 shows an interline image sensor with vertical registers,
Figure 8 shows how an electric black reference signal can be generated by a feedback circuit,
Figure 9 shows a selector for selecting either short exposure or long exposure,
and
Figure 10 shows an image sensor system and an electric chip system.

### DETAILED DESCRIPTION OF AN EMBODIMENT

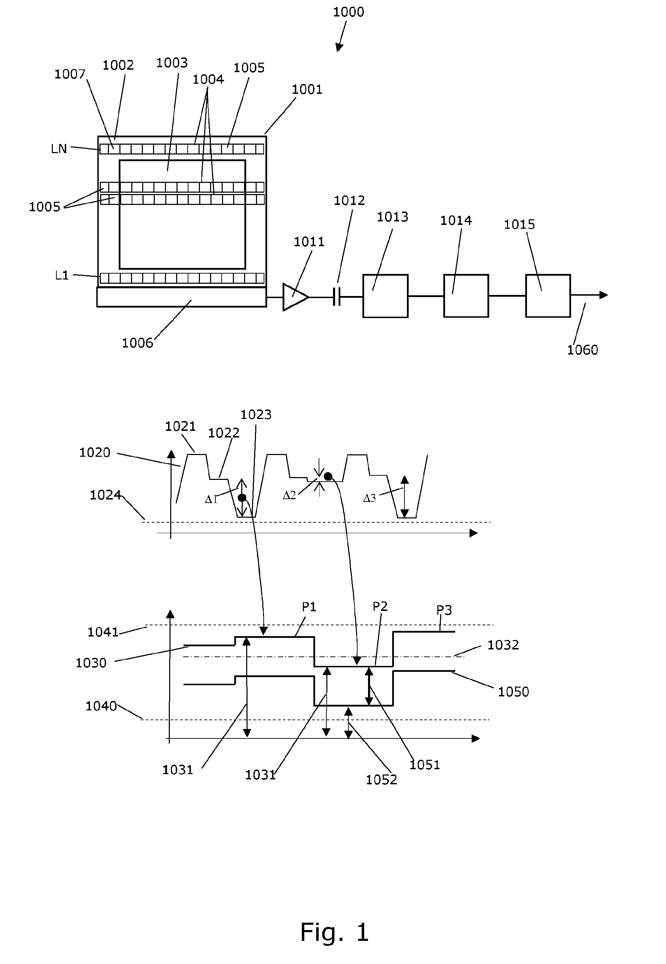

Figure 1 illustrates an image sensor system 1000 comprising an image sensor 1001, a horizontal register 1006, an amplifier 1011, a capacitor 1012, Correlated Double Sampler (CDS) 1013, a clamping circuit 1014 and an analogue to digital converter (ADC) 1015.

The image sensor 1001 contains lines of pixels 1004 where each line 1004 contains a number of photosensitive pixels 1005. Each pixel 1005 is capable of storing an amount of electric charge corresponding partly to the amount of light radiated onto the pixel. However, the amount of charge stored in the pixel 1005 is also influenced by optical noise sources, for example black current, and other electrical noise sources. Accordingly the charge stored in the pixels 1005 originates primarily from light radiated onto the pixel 1005, optical noise sources and electrical noise sources.

The image sensor 1001 has en active area 1003 where light radiation propagates freely into the pixels 1005. The image sensor also has a shielded area 1002 where the pixels 1005 are shielded so that light cannot propagate into the pixels. Accordingly, charge stored in the light shielded pixels 1005 originates primarily from optical noise sources and electrical noise sources. Those pixels 1005 that are located in the shielded area 1002 are referred to as shielded pixels 1007.

The image sensor 1001 is typically used in a camera for imaging for example a landscape onto the active area 1003 by means of an imaging lens. The charges stored in the image sensor 1001 are readout and processed to form a digital image.

The optical black noise generally refers to any kind of undesired current or voltage generated by the photosensitive pixels 1005. The optical black noise may be dependent or independent of the light radiated onto the pixels 1005 and may be dependent of for example the temperature of the photosensitive pixels 1005. Thus, the term "black" refers to the fact that the optical black noise is generated even if no light is radiated into the pixels.

The image sensor 1001 may be a charge coupled image sensor (CCD), a CMOS image sensor or other image sensors known to the skilled person. Similarly, the image sensor 1001 may full frame type, a interline type or other types.

The pixels 1005 are read out from image sensor via the horizontal register 1006. Initially, the charges of the pixels 1005 of the first line L1 are transferred to the horizontal register. The charges are read out from the horizontal register 1006 as a video signal 1020. The video signal 1020 may be amplified by amplifier 1011 and it may be filtered by capacitor 1012 before the image signal is supplied to the Correlated Double Sampler (CDS) 1013.

The video signal 1020 includes a reset pulse 1021, a reference level 1022 and a pixel level 1023. The value of reference level 1022 may be affected by residue charges of the capacitor 1012 and, therefore, the reference level 1022 may not constant during reading out the pixels 1005. The difference of the reference level 1022 and the pixel level 1023 corresponds to the charge stored in a single pixel 1005. The maximum level of the video signal 1020 is indicated by the maximum level 1024.

The Correlated Double Sampler (CDS) 1013 generates the image signal 1030 having pixel levels 1031 corresponding to the difference between the reference level 1022 and the pixel level 1023. Thus, the pixel level 1031 of pixel P1 corresponds to the difference Δ1 between the reference level 1022 and the pixel level 1023, the pixel level 1031 of pixel P2 corresponds to Δ2, the pixel level 1031 of pixel P3 corresponds to Δ3, and so on.

Now, the image signal 1030 could be transmitted to the analogue to digital converter (ADC) 1015. The ADC 1015 digitizes the image signal into a digital image signal, for example a 16 bit digital signal. The ADC is characterised by a lower clipping limit 1040 and a full scale limit 1041. In order not do destroy the digital image from the image sensor, the pixel level 1031 of the image signal 1030 should not go below the lower clipping limit 1040. On the other hand, if the pixel level 1031 of the image signal 1030 exceeds the full scale limit 1041 the pixel level 1031 will be clipped to the value of the full scale limit 1041. Thus, to fully exploit the dynamic range of the ADC 1015, the reference level 1032 of the image signal 1030 should be adjusted so that a minimum pixel level 1031, eg. the pixel level 1031 of pixel P2, does not go below the lower clipping limit 1040.

Therefore, the image signal 1030 is supplied to the clamping circuit 1014 which adjusts the reference level 1032 of the image signal relative to the lower clipping reference 1040 resulting in a clamped image signal 1050 transmitted by the clamping circuit. Thus, the clamping circuit 1015 ensures that any pixel level 1031 does not go below the clipping limit 1040 and, thereby, avoids clipping of the clamped image signal 1050.

Thus, the value of the level shift 1051 between the image signal 1030 and the clamped image signal 1050 must be chosen carefully in order to avoid clipping of the clamped image signal 1050.

The pixel levels 1031, which are equivalent to the charges stored in the pixels 1005, are generated by contributions primarily from light radiated onto the pixels 1005, optical noise sources and electrical noise sources.

The configuration of the image sensor system 1000 is not limited to the configurations depicted in the figures but may be configured differently. For example, one or more of the the amplifier 1011, the CDS 1013, the clamping circuit 1014 and the ADC 1015 may be combined into one or more circuits, such as the CDS 1013 being combined with the clamping circuit 1014 into a combined CDS and clamping circuit 1014. Also, one or more of the circuits may be integrated with the image sensor 1001 or the horizontal register 1006.

The signals, i.e. the image signal 1030, 1050, the digital image signal 1060 and the video signal 1020, are not limited to those particular signal types illustrated in the Figures. Clearly, other image sensors and those electronic circuits related to the image sensor, for example the register 1006, the amplifier 1011, the CDS 1013, the clamping circuit 1014 and the ADC 1015, may be configured to provide other types of image signals. Therefore, reference to the video signals 1020 and the image signals 1030, 1050 is not limited to particular signals illustrated in the figures or described. Accordingly, reference to an image signal 1020, 1030, 1050 should be understood as a reference to any image signal 1030, 1050, video signal 1020 or digital image signal 1060. Oppositely, reference to a video signal 1020 or an image signal 1030, 1050 should not be limited to that particular signal, since in general image signals and video signals may have different forms.

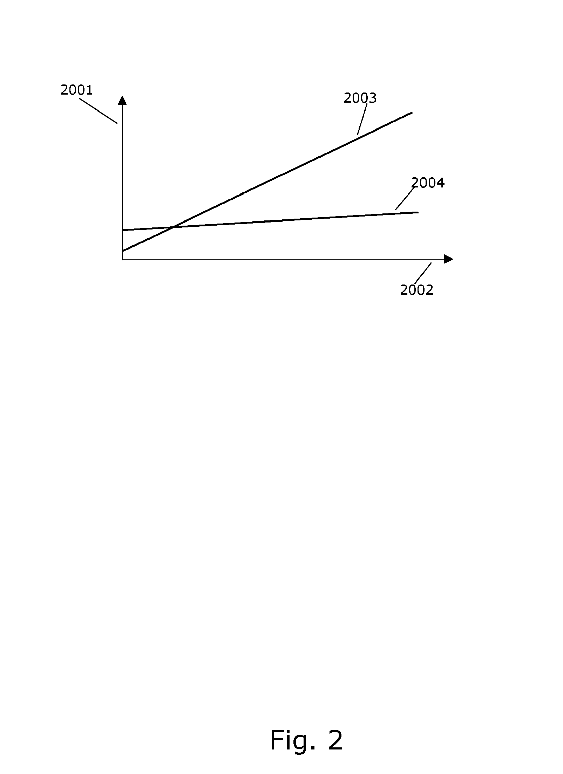

The curves 2003 and 2004 in Figure 2 illustrates the fraction (along the ordinate 2001) of the pixel level 1031 which is caused by optical noise 2003 and the electrical noise 2004 as a function of exposure time 2002. The exposure time is the period of time in which the pixels 1005 are exposed to light being imaged onto the image sensor 1001, for example by an imaging lens.

Accordingly, by adjusting the reference level 1032 of the image signal 1030, for example by providing a level shift 1051 to the image signal 1030 corresponding to a value of the optical noise 2003 or the electrical noise 2004, would bring a minimum pixel level 1031 closer to clipping limit 1040 and, thereby, increase the dynamic range of the analogue to digital converter 1015. An increased dynamic range implies a higher resolution of the digital signal generated by the ADC 1015.

Furthermore, by adjusting the reference level 1032 of the image signal 1030 using a value or a signal corresponding to the optical noise 2003 or the electrical noise 2004 would also compensate the image signal 1030 for the optical noise 2003 or the electrical noise 2004, respectively. That is, a truer image signal 1030 is obtained since unwanted noise is removed from the image signal 1030.

However, when adding or subtracting a level shift 1051 to the image signal 1030 it must be assured that the pixel level 1052 of the clamped image signal 1050 does not exceed the lower clipping limit 1040.

An optical black reference signal representing the optical noise 2003 can be obtained by reading out shielded pixels, for example by averaging a number of shielded pixels 1007 for each line 1004 or a number of lines 1004 to obtain an optical black reference signal or an optical black reference value. Experiences have shown that use of an optical black reference signal to provide a level shift 1051 to the image signal 1030 may cause clipping of the clamped image signal 1050 since one or more pixel levels 1052 exceed the lower clipping limit 1040. This is particularly the case for long exposure times. A Long exposure time may be considered as an exposure time longer than 0.01 second eg. under normal daylight photographing, longer than 0.1 second eg. for photographing under weak light conditions, longer than one second or even longer than one minute eg. for photographing under very low light conditions such as night photographing. In the extreme the exposure time may be measured in hours.

However, it has been observed that use of a signal value equivalent to the electrical noise 2004 is useful to provide a level shift 1051 to the image signal 1030. In particular it has shown that the use of a signal value equivalent to the electrical noise 2004 does not cause any lower pixel levels 1052 to exceed the lower clipping limit 1040 and, therefore, the quality of the digital image is not decreased due to clipping of the clamped image signal 1050.

Thus, by using a signal or a value corresponding to the electrical noise 2004, the dynamic range of the ADC 1015 is better exploited without causing clipping of the clamped image signal 1050. In addition, since the level shift 1051 applied to the image signal 1030 corresponds to the electric noise 2004, the electric noise 2004 is removed, or at least partially removed, from the image signal 1030 so that a more correct digital image is obtained.

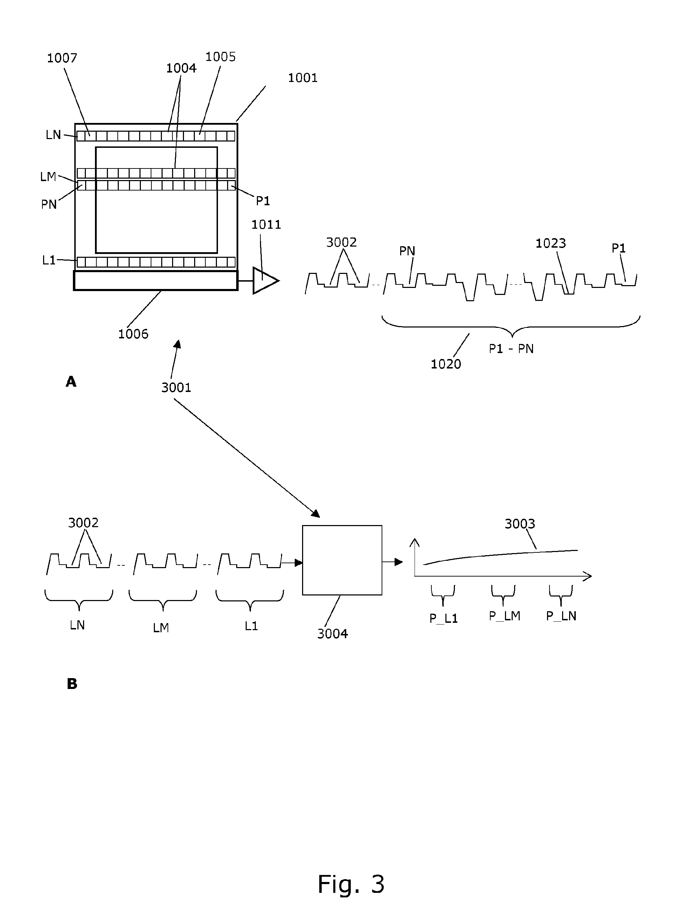

Figure 3 shows in one example of an electric reference generator 3001 how the horizontal register 1006 can be used as the electric reference generator 3001 to provide an electric black reference signal 3003 corresponding to the electrical noise 2004.

The term "black" in the electric black reference signal 3003 refers to the fact that the electric black reference signal 3003 corresponds to electrical noise 2004 being generated even when the pixels 1005 are not exposed to light.

In part A of Figure 3 the pixels P1-PN, comprising pixels 1005 from the active area 1003 and the shielded area 1002, of line LM are readout as the video signal 1020 comprising pixel values 1023. By reading out or transmitting one or more additional values 3002 from the horizontal register subsequent to reading out the pixel values 1023, the additional values 3002 can be used to obtain the electric black reference signal 3003 as will be described in relation to part B of Figure 3.

Part B of Figure 3 shows how a sequence of additional values 3002 are readout for a sequence of lines L1-LN. The electric black reference signal 3003 may be generated from the additional values 3002 for example by sampling the additional values 3002 and subsequently averaging or filtering the sampled additional values 3002 using a filter 3004 so as to obtain a smooth and continuous electric black reference signal 3003, for example as depicted. For example the additional values 3002 from line L1 may be combined, eg. by averaging, to form a single electric noise value for line L1, or only one additional value 3002 may be extracted for each line 1004 to form a single electric noise value for each line 1004. To form the continuous electric black reference signal 3003, the electric noise values for each line 1004 may be combined, eg. by filtering. In an alternative the electric black reference signal 3003 may be obtained directly from the additional values 3002 without performing filtering or averaging, for example by sampling the additional values 3002. If a filter 3004 is used it may be integrated with the electric reference generator 3001 or otherwise provided with the image sensor system 1000.

Since the electric noise 2004 varies during readout of the lines 1004 of pixels 1005, the electric reference generator 3001 may be configured to provide values of the electric black reference signal 3003 for a one or more of lines 1004 (eg. lines L1,..,LM,..,LN) of the image sensor 1001. As shown in part B of Figure 3, additional values 3002 associated with one or more of lines L1,..,LM,..,LN are converted to form the electric black reference signal 3003. Values of the electric black reference signal 3003 corresponding to one or more lines L1,..,LM,..,LN may be obtained from the electric black reference signal 3003 for example by sampling the electric black reference signal 3003 within periods P_L1,..,P_LM,..,P_LN corresponding to lines L1,..,LM,..,LN.

It should be understood that additional values 3002 may be selected from only one line 1004 to form the electric black reference signal 3003, or values 3002 may be selected from every second, every third, etc. line 1004 to form the electric black reference signal 3003.

Accordingly, for operating the clamping circuit 1014 on a line-by-line basis, the clamping circuit 1014 is configured to adjust a plurality of reference levels 1032 of the image signal 1030 related to a plurality of lines L1,..,LM,..,LN using values of the electric black reference signal 3003 corresponding to respective lines L1,..,LM,..,LN. Accordingly, level shifts 1051 are applied to the image signal 1030 for a plurality of lines L1,..,LM,..,LN of the image signal 1030, where each level shift 1051 is obtained from the electric black reference signal 3003 for corresponding lines L1,..,LM,..,LN.

It should be understood that level shifts 1051 may be applied to the image signal 1030 of any number of lines 1004. For example, only one level shift 1051 may be applied to one line 1004 of the lines L1-LN, or level shifts 1051 may be applied to every second, every third, etc. lines 1004.

It may be an advantage that the electric black reference signal 3003 is smooth and continuous so that the level shifts 1051 applied to the image signal 1030 does not change too much between lines 1004. If the level shifts 1051 changes too much between lines 1004 this may result in visible fringes in the digital image.

The electric black reference signal 3003 may be generated by other means than the horizontal register 1006 or the filter 3004. In general the black reference signal 3003 may be generated from any electric value corresponding to the electrical noise 2004.

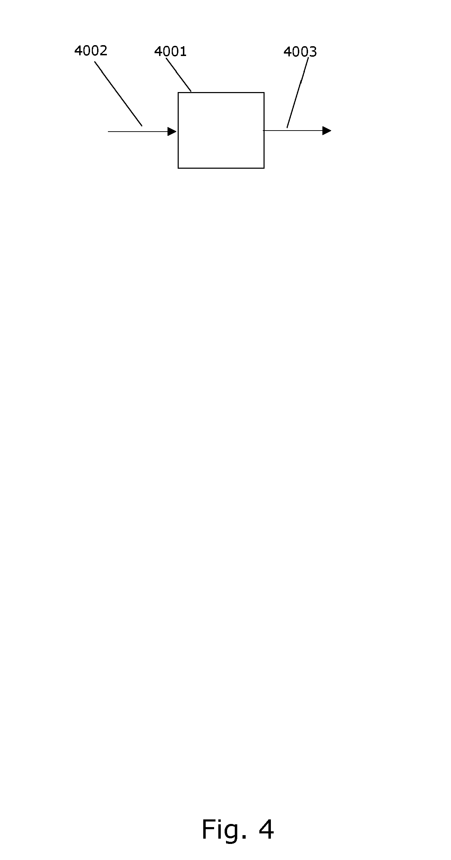

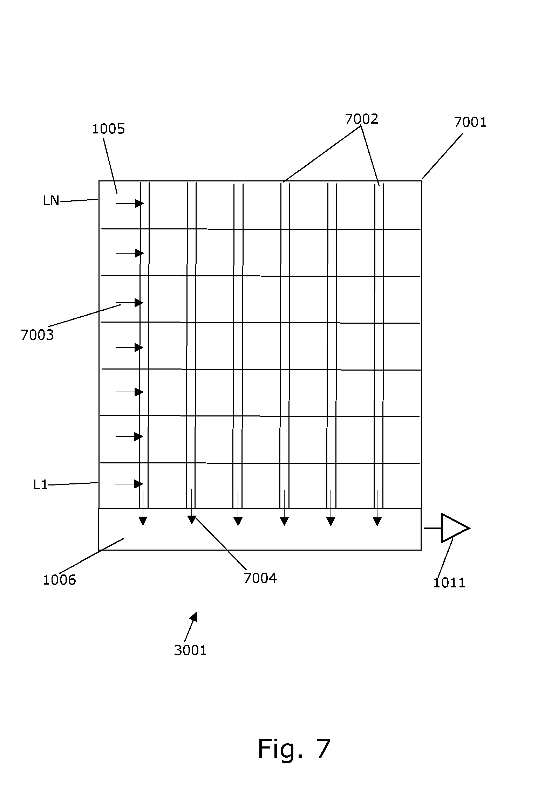

Figure 7 shows an interline image sensor 7001 comprising pixels 1005, vertical registers 7002, a horizontal register 1006 and an amplifier 1011. The charges stored in the pixels 1005 are readout from the image sensor 7001 by first shifting the charges from the pixels 1005 to the vertical registers 7002 as indicated by arrows 7003. From the vertical registers 7002 the charges are shifted into the horizontal register 1006 starting from line L1 as indicated with arrows 7004. When the charges from the last line LN has been readout into the horizontal register 1004, the vertical registers have been emptied for charges generated by the pixels 1005. However, by carrying out another shift of the vertical registers 7002 into the horizontal register 1006, the horizontal register 1006 will be filled with charges having values corresponding to the electrical noise 2004. By transmitting these additional values of electrical noise 2004 from the vertical registers 7002 and using a filter 3004 for performing filtering or averaging to obtain an electric black reference signal 3003, the image signal 1030 can be converted into the clamped image signal 1050, for example by subtracting values of the electric black reference signal 3003 from the image signal 1030 as described in relation to Figure 4. Clearly, one or more additional values of electrical noise 2003 can be transmitted from only one vertical register or from a plurality of vertical registers 7003. Accordingly, the vertical registers 7002 in combination with the horizontal register 1006 can be seen as an electric reference generator 3001.

The generation of an electric black reference signal 3003 is not limited to using values from additional values transmitted by the horizontal register 1006 or additional values transmitted from one or more vertical registers 7002. Indeed, the electric black reference signal 3003 can be generated by data processing or data analysis of other image signals, such as the video signal 1020, the image signal 1030 or the digitized image signal 1060.

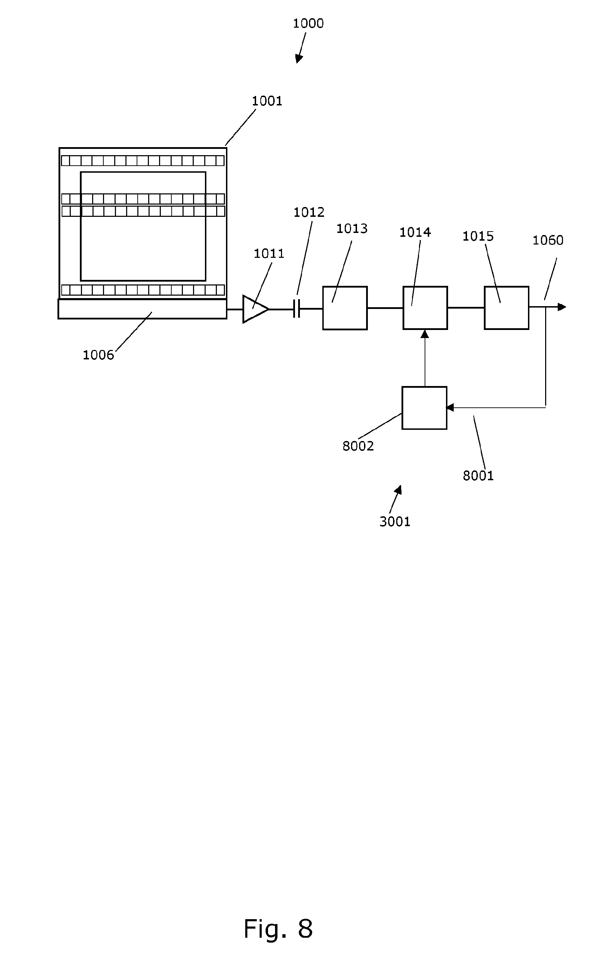

Figure 8 shows how the electric black reference signal 3003 can be generated by a feedback circuit 8001 using the digitized image signal 1060 as a feedback signal. The feedback signal is processed by the processing device 8002. Thus, the processing device extracts electric noise values 2003 from a digitised image signal 1060 and converts the extracted electric noise values into the electric black reference signal 3003. The electric black reference signal 3003 is supplied to the clamping circuit 1014 so that the reference level 1032 of the image signal 1030 is adjusted relative to the lower clipping reference 1040 of the ADC 1015 so that clipping of the clamped image 1050 signal is avoided. The feedback circuit 8001 and the processing device may be configured to adaptively generate the electric black reference signal 3003 so the reference level 1032 of the image signal 1030 is adaptively adjusted relative to the reference level 1032. Thus, in this feedback example the feedback circuit 8001 and the processing device 8002 can be seen as an electric reference generator 3001.

After the electrical black noise 2004 has been removed from the image signal 1030, the resulting clamped image signal 1050 can be supplied to the analogue to digital converter 1015 which converts the clamped image signal into a digitized image signal 1060 read out from the analogue to digital converter 1015.

The digital image signal 1060 which has been corrected for electrical noise 2004 still contains optical noise 2003. However, the digitized image signal 1060 can be corrected for optical black noise 2003 by use of the shielded pixels 1007. The shielded pixels 1007 are not exposed to light during exposure of the digital image and, therefore, the charges stored in the shielded pixels 1007 corresponds to the optical black noise 2003.

The pixel levels 1032 of the shielded pixels 1007 can be extracted either from the analogue image signal 1030 or from the digitized image signal 1060. Since each line 1004 contains one or more shielded pixels 1007, one pixel level 1032 or more pixel levels 1032 from corresponding shielded pixels 1007, eg from line LM, can be filtered or averaged to form a single optical black value representing the optical black noise for line LM.

Figure 4 shows an optical black noise compensator 4001 configured to correct the digitized image signal for optical black noise by adjusting the level of the digitized image signal 1060 relative to the optical black values. For example this may be carried out by subtracting the optical black values of each line 1004 from the digitized image signal 1060. Alternatively, an optical black reference signal may be generated by filtering or averaging all the optical black values obtained for each line 1004 so as to generate a smooth and continuous optical black reference signal. By using values from the optical black reference signal and subtracting those values from the digitized image signal 1060 a black-level conditioned digitized image signal which is substantially corrected for optical black noise 2003 is obtained.

The optical black noise compensator 4001 may be supplied with the digitized image signal 1060 via input 4002. From the digitized image signal 1060 which contains pixels levels 1023 both from shielded pixels 1007 and pixels 1005, the optical black noise compensator 4001 may generate the optical black reference signal and/or optical black values, and by using the optical black reference signal or the optical black values the optical black noise compensator 4001 may generate and transmit a black-level conditioned signal via output 4003.

In general the black level compensator 4001 is configured to adjust the digitized image signal 1060 by adjusting each line 1004 of the image sensor, where each line is adjusted using values originating from one or more shielded pixels 1007 from one or more lines 1004 to obtain a black-level conditioned digitized image signal. That is, for example the value from only one shielded pixel 1007 selected from any line 1004 may be used to adjust each line 1004, or the values from shielded pixel 1007 selected by selecting one shielded pixel from each of a plurality of lines 1004, eg. every second line, may be used to adjust each line 1004, or the values from shielded pixel 1007 selected by selecting a plurality of shielded pixel from each of a plurality of lines 1004, eg. every second line, may be used to adjust each line 1004. In a preferred embodiment a plurality of pixel values 1032 from shielded pixel 1007 are averaged for each line 1004, and the averaged values from all lines 1004 are filtered to obtain an optical black reference signal, and the optical black reference signal is used to generate the black-level conditioned signal.

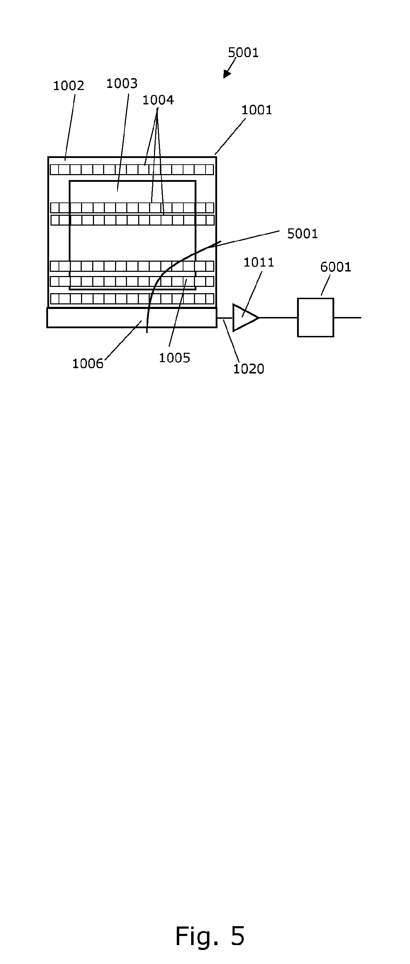

Figure 5 shows an image sensor system 5001 comprising an image sensor 1001, a horizontal register 1006, an amplifier 1011 and an output stage 6001. Figure 5 illustrates how heating of the amplifier 1011 causes localised optical black noise from pixels 1005 located within a heated area 5001 of the image sensor 1001. During readout of pixels 1005 from the horizontal register 1006 the amplifier 1011 amplifies the image signal 1020, however, the amplifier 1011 also generates heat. The heat from the amplifier 1011 causes localised heating of the pixels 1005 located approximately within an area 5001. The increased temperature of the pixels 1005 causes generation of an increased amount of optical black noise 2003 from the pixels located within area 1005 compared to the pixels 1005 located outside the area 5001.

Even though the amplifier 1011 is depicted as an external device, it should be understood that amplifier 1011 may integrated with the image sensor 1001 or the horizontal register 1006. Alternatively, the amplifier 1011 may be placed otherwise in the vicinity of the image sensor 1001.

The image signal 1020 may be compensated for localised optical black noise by converting the image signal 1020 into a digitized image signal 1060 and compensating the digitized image signal 1060 for localised optical black noise by processing the digitized image signal.

The amplifier 1011 generates heat both during readout of pixels 1005 and during the exposure period of the pixels 1005. For long exposure periods considerable amounts of localised optical black noise are generated. However, since no image signal 1020 is readout during the exposure period the amplifier 1011 serves no purpose during the exposure period. Accordingly, the amplifier 1011 could simply be switched off during the exposure period by switching off the power supply to the amplifier. However, completely switching off the amplifier 1011 has some drawbacks.

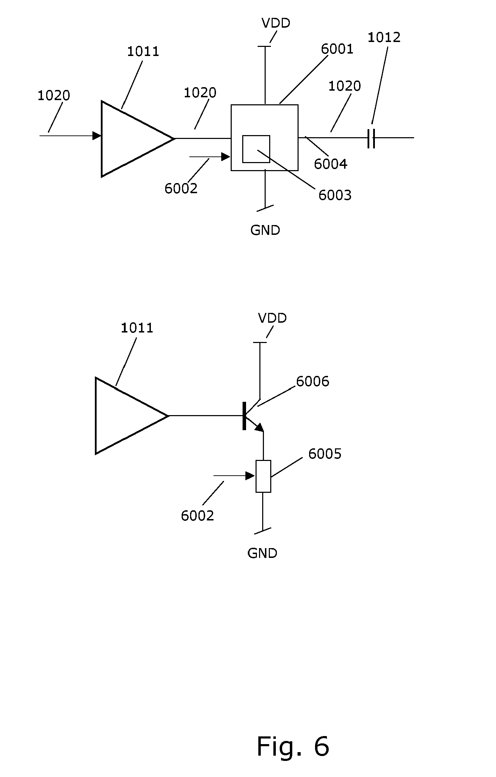

Figure 6 shows an output stage 6001 connected to the output of the amplifier 1011. The function of the output stage 6001 is to provide conditioning of the image signal 1020, such as current amplification. However, during the image exposure period there is no need for signal conditioning or current amplification by the output stage 6001. Therefore the output stage is provided with a current controller 6003. When supplied with a current control signal 6002 the current controller 6003 reduces the current amplification which has the effect that the power consumption by the amplifier 1011 is reduced since a reduced current is drawn from the amplifier 1011. The reduced power consumption by the amplifier 1011 results in reduced heat generation from the amplifier 1011. The reduced heat generation from the amplifier 1011 has the effect that pixels 1005 located within the area 5001 generates no optical black noise or at least generates a smaller amount of optical black noise due to localised heating.

The current controller 6003 may be configured so that the voltage on the output terminal 6004 of the output stage 6001 is unaffected by the reduced current amplification of the output stage 6001. Accordingly, when the image exposure period has ended and the readout of pixels 1005 from the image sensor 1001 has to begin the voltage on the output terminal 6004, and therefore the voltage over the capacitor 1012 has the correct level.

In an embodiment the current controller 6003 is a controllable resistor 6005 and the output stage 6001 is a semiconductor device 6006, for example a transistor, configured as a current buffer. In this embodiment the current amplification by the semiconductor device 6006 and, thereby, the heating generated by the amplifier 1011, is controllable via the controllable resistor 6005 having a resistance being controllable via the current control signal 6002.

It may be beneficial to be able to select different image exposure modes in dependence of the length of the exposure period. Clearly, for long exposure periods the clamping circuit 1014 should adjust the reference level 1032 of the image signal 1030 using the electric black reference signal 3003 obtained from an electric reference generator 3001. However, for short exposure periods, eg shorter than 0.1 seconds, preferable shorter than 0.01 seconds, it may in some situations be beneficial to configure the clamping circuit 1014 to adjust the reference level 1032 of the image signal 1030 using an optical black reference signal or optical black values as described in connection with Figure 4. Therefore, it may be beneficial to be able provide the clamping circuit 1014 with the electrical black reference signal 3003 or the optical black reference signal in dependence of the length of the image exposure period.

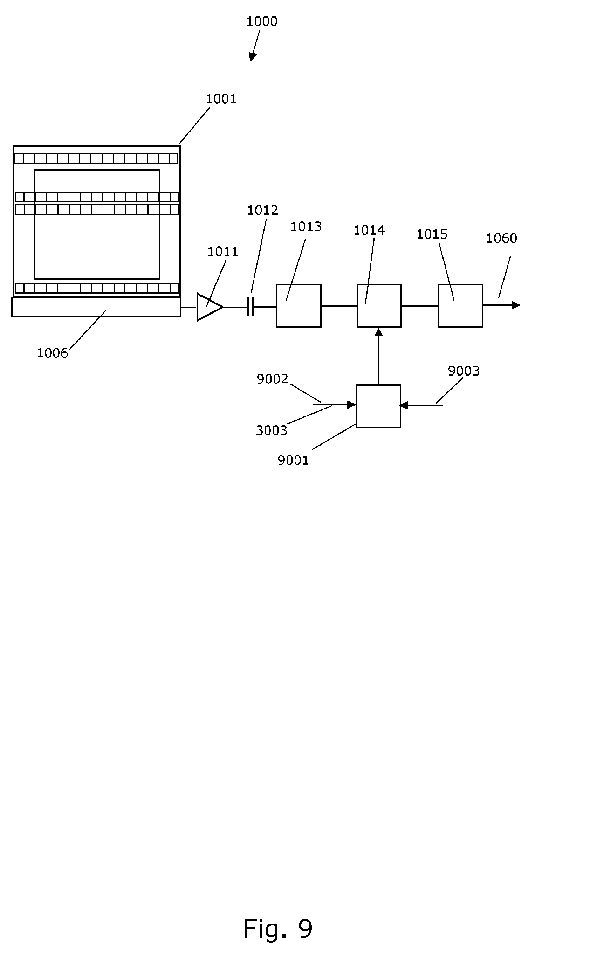

Figure 9 shows a configuration of the image sensor system 1000 comprising a selector 9001 for selecting either a short exposure mode or a long exposure mode so that the selector provides the clamping circuit 1014 with the electric black reference signal 3003 when the long exposure mode is selected and the selector provides the clamping circuit 1014 with the optical black reference signal or optical black values when the short exposure mode is selected. The selection of the short or long exposure modes may be carried out automatically, for example by a processing device of a camera, or the selection may be carried out manually, for example by the user of a camera.

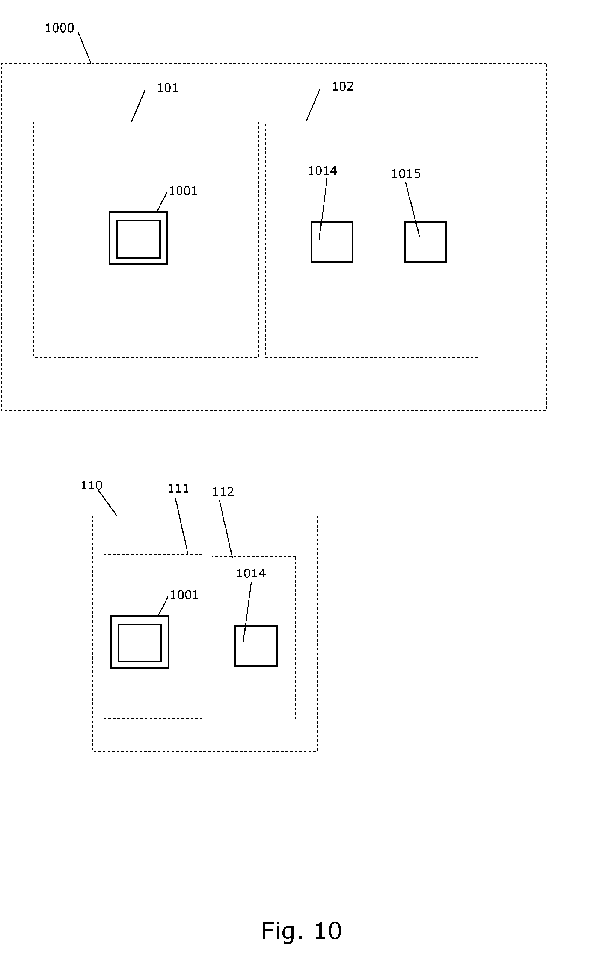

Figure 10 shows an image sensor system 1000. As indicated by subsystems 101 and 102, the image sensor system 1000 may be comprised by one or more subsystems corresponding to subsystems 101 and 102. For example, one subsystem 101 may comprise the image sensor 1001. The other subsystem 102 may for example comprise the clamping circuit 1014 and the analogue to digital converter (ADC) 1015. Clearly, the devices and components of the image sensor system may be grouped differently in various subsystems. Also, in this or other embodiments the subsystems 101 and 102 may comprise further devices, for example subsystem 101 may comprise anyone or more of the horizontal register 1006, the amplifier 1011. Also, in this or other embodiments the subsystem 102 may comprise anyone or more of the capacitor 1012 and the Correlated Double Sampler 1013.

The image sensor system 1000 comprises an electric reference generator 3001 which may be comprised by the subsystem 101 or 102 or other subsystems comprised by the image sensor system 1000. As described previously, the electric reference generator 3001 may be embodied by the horizontal register 1006, the vertical registers 7002 in combination with the horizontal register 1006, or the feedback circuit 8001 in combination with the processing device 8002.

In an embodiment, the image sensor system 1000 comprises a black level compensator 4001. In another embodiment the image sensor system 1000 comprises a selector 9001. In a further embodiment the image sensor system 1000 comprises an output stage 6001. In an embodiment the image sensor system comprises a filter 3004 for use with the electric reference generator 3001.

One of the subsystems comprised by the image sensor system may be an electronic chip system 110, for example an integrated electronic circuit. The electronic chip system 110 may comprise the image sensor 1001 and the clamping circuit 1014. Again, the electronic chip system 110 may be divided into two subsystems 111 and 112, where subsystem 111 comprises the image sensor 1001 and subsystem 112 comprises the clamping circuit 1014.

The subsystems 101 of 102 of the image sensor system 1001 and/or the subsystems 111 and 112 of the electronic chip system 110 may be comprised by a single apparatus, for example a camera. Alternatively, anyone or more of the subsystems 101 of 102 of the image sensor system 1001 and/or the subsystems 111 and 112 of the electronic chip system 110 may be distributed over different apparatuses. For example, subsystem 101 may be contained in a camera whereas the subsystem 102 may be contained in an auxiliary apparatus (not depicted) connectable with the camera. Similarly, the electronic chip system 110 may comprised by a single integrated electronic circuit. Alternatively, the electronic chip system 110 may comprised by for example two electronics chip systems corresponding to the subsystem 111 and the subsystem 112, respectively.

Anyone or more of the subsystems 101 of 102 of the image sensor system 1001 and/or the subsystems 111 and 112 of the electronic chip system 110 may be implemented in hardware or in software. The hardware may be an electronic circuit, such as components on a printed circuit board, or the hardware may be an integrated electronic circuit, such as an electronic chip device.

The software may be embedded software, such as software embedded in an electronic chip circuit, or the software may be a computer program adapted for running on a computer.

Accordingly, the image sensor system 1000 may comprise a subsystem 101 implemented in hardware and a subsystem 102 implemented in software. Similarly, the electronic chip system 110 may comprise a subsystem 111 implemented in hardware and a subsystem 112 implemented in software.

In an alternative embodiment of the invention, the image sensor system 1001 or the electronic chip device 110 comprises an output stage 6001 and a current controller 6003. The output stage 6001 and/or the current controller 6003 may be implemented in hardware and/or software.

In the above description various figures have been reused for different embodiments. When elements of a figure have already been explained in relation to a previous embodiment, those elements are not necessarily explained in relation to the new embodiment since the function of that element, eg the amplifier 1011, in the new embodiment is identical to or equivalent to the function in the previous embodiment.

Embodiments of the invention relate to:
An image sensor system 1000 configured to adjust a reference level 1032 of an image signal 1030 readout from an electronic image sensor 1001, the image signal 1030 representing analogue pixel values of a digital image recorded by the image sensor 1001, the image sensor system comprising,
   - an electric reference generator 3001 configured to provide an electric black reference signal 3003,
   - a clamping circuit 1014 configured to obtain a clamped image signal 1050 by adjusting the reference level 1032 of the image signal readout from the electronic image sensor 1001 using the electric black reference signal 3003,
   - an analogue to digital converter 1015 having a lower clipping reference 1040 for digitizing the clamped image signal 1050,
wherein the reference level 1032 of the image signal 1030 is adjusted relative to the lower clipping reference 1040 for avoiding clipping of the clamped image signal 1050, and the clamped image signal 1050 is obtained prior to digitizing the clamped image signal.

An image sensor system wherein the electric black reference signal 3003 represents electric noise 2003 embedded in the image signal 1030.

An image sensor system wherein the electric black reference signal 3003 is substantially free from optical noise 2004 being embedded in the image signal 1030.

An image sensor system wherein the electric black reference signal 3003 is generated from one or more additional values 3002 transmitted by a horizontal register 1006, where the additional values 3002 are transmitted by the horizontal register 1006 subsequent to pixel values 1023.

An image sensor system wherein the electric black reference signal 3003 is generated from one or more additional values 3002 transmitted from one or more vertical registers 7002 of the image sensor 1001,7001, where the additional values 3002 are transmitted from the vertical registers 7002 subsequent to pixel values 1023.

An image sensor system wherein the electric black reference signal 3003 is generated by a feedback circuit 8001 comprising a processing device 8002 configured to extract electric noise values 2003 from a digitised image signal 1060 and converting the extracted electric noise values into the electric black reference signal 3003.

An image sensor system wherein
- the electric reference generator 3001 is configured to provide an electric black reference signal 3003 comprising values of one or more lines 1004 of the image sensor 1001, and
- the clamping circuit 1014 is configured to adjust one or more reference levels 1032 of the image signal 1030 related to corresponding one or more of lines 1004 of the image sensor 1001 using the electric black reference signal 3003, where the adjusted reference levels 1032 of the image signal 1030 have values relative to the lower clipping reference 1040 for avoiding clipping of the clamped image signal.

An image sensor system wherein
- the analogue to digital converter is configured to convert the clamped image signal 1050 into a digitized pixel signal 1060, the system further comprising,
- a black level compensator 4001 configured to adjust the digitized image signal 1060 related to each line 1004 of the image sensor, where each line 1004 is adjusted using values originating from one or more shielded pixels 1007 from one or more lines 1004 to obtain a black-level conditioned digitized image signal.

An image sensor system according to any of the preceding claims, further comprising a selector 9001 for selecting an exposure mode selected from the list comprising: a short exposure mode and a long exposure mode, wherein
- the selector 9001 is configured to provide the clamping circuit 1014 with the electric black reference signal 3003 when the long exposure mode is selected, and
- the selector 9001 is configured to provide the clamping circuit 1014 with an optical black reference signal when the short exposure mode is selected.

An image sensor system according to any of the preceding claims, further comprising
- an amplifier 1011 capable of amplifying the image signal 1020,
- an output stage 6001 capable of conditioning the amplified image signal 1020, and
- a current controller 6003 capable of controlling a power consumption of the amplifier 1011 during the image exposure period by controlling a current in the output stage 6001 for reducing heating of the image sensor 1001.

An electronic chip system 110 configured to adjust a reference level 1032 of an image signal 1030 readout from an electronic image sensor 1001, the image signal 1030 representing analogue pixel values of a digital image recorded by the image sensor 1001, the electronic chip system comprising,
- an electric reference generator 3001 configured to provide an electric black reference signal 3003,
- a clamping circuit 1014 configured to obtain a clamped image signal 1050 by adjusting the reference level 1032 of the image signal 1030 readout from the electronic image sensor 1001 using the electric black reference signal 3003, wherein the reference level 1032 of the image signal is adjusted relative to a lower ADC-clipping reference 1040 for avoiding clipping of the clamped image signal.

A method for adjusting a reference level 1032 of an image signal 1030 readout from an electronic image sensor 1001, the image signal 1030 representing analogue pixel values of a digital image recorded by the image sensor 1001, the method comprising,
- providing an electric black reference signal from an electric reference generator,
- adjusting the reference level of the image signal read out from the electronic image sensor using the electric black reference signal for obtaining a clamped image signal,
- digitizing the clamped image signal using an analogue to digital converter ADC having a lower clipping reference,
wherein the reference level of the image signal is adjusted relative to the lower clipping reference for avoiding clipping of the clamped image signal, and the clamped image signal is obtained prior to digitizing the clamped image signal.

## Claims

1. An image sensor system (5001) configured to reduce amplifier heating of electronic image sensor (1001), the image sensor (1001) being configured to provide an image signal (1020) representing analogue pixel values of a digital image recorded by the image sensor (1001), the image sensor system comprising
- an amplifier (1011) capable of amplifying the image signal (1020),
- an output stage (6001) capable of conditioning the amplified image signal (1020), and
- a current controller (6003) capable of controlling a power consumption of the amplifier (1011) during the image exposure period by controlling a current in the output stage (6001) for reducing the heating of the image sensor.

2. The image sensor system according to claim 1, wherein the current controller (6003) is capable of maintaining an output voltage of the output stage (6001) substantially constant during the image exposure period.

3. The image sensor system according to any of claims 1-2, wherein the current controller (6003) is a controllable resistor (6005).

4. The image sensor system according to any of claims 1-3, wherein the output stage (6003) is a semiconductor device (6006) configured as current buffer.
